# EUROPÄISCHE PATENTSCHRIFT

(11) **EP 1 330 883 B1**
(45) Veröffentlichungstag und Bekanntmachung des Hinweises auf die Patenterteilung: **23.08.2006**
(21) Anmeldenummer: 01993067.6
(22) Anmeldetag: 01.11.2001
(51) Int. Cl.: H04B 1/08, B60R 11/02, H05K 5/00

(54) **ELEKTRONISCHES GERÄT**
ELECTRONIC DEVICE
APPAREIL ELECTRONIQUE

(30) Priorität: 03.11.2000 DE 10054589
(43) Veröffentlichungstag der Anmeldung: 30.07.2003
(73) Patentinhaber: SIEMENS AKTIENGESELLSCHAFT, 80333 München (DE)
(72) Erfinder: REINHARDT, Jörg, 35633 Lahnau (DE); SPRATTE, Joachim, 49090 Osnabrück (DE)
(86) Internationale Anmeldenummer: PCT/DE2001/004094
(87) Internationale Veröffentlichungsnummer: WO 2002/037702

(56) Entgegenhaltungen:
- EP-A- 0 194 962
- EP-A- 0 501 192
- PATENT ABSTRACTS OF JAPAN vol. 016, no. 230 (E-1208), 27. Mai 1992 (1992-05-27) & JP 04 043724 A (KENWOOD CORP), 13. Februar 1992 (1992-02-13)

## Beschreibung

Die Erfindung betrifft ein elektronisches Gerät mit mehreren, übereinander oder nebeneinander angeordneten Hauptleiterplatten, von denen eine beispielsweise elektronische Bauteile eines Radios, die andere elektronische Bauteile eines Multimediagerätes und eine dritte elektronische Bauteile einer Fahrzeugnavigation trägt und die zur elektrischen Verbindung miteinander an ihrer Vorderseite jeweils ein Steckverbindungsteil aufweisen.

Elektronische Geräte der vorstehenden Art sind beispielsweise in heutigen Kraftfahrzeugen vorgesehen und deshalb bekannt. Da zwischen den einzelnen Hauptleiterplatten im Regelfall ein Signalaustausch stattfinden muss, besteht die Notwendigkeit, diese miteinander elektrisch zu verbinden. Das erfolgt bei den bisher bekannten Geräten dadurch, dass an den Frontseiten Steckverbindungsteile vorgesehen sind, so dass man mittels elektrischer Leitungen die erforderlichen Verbindungen zwischen den Hauptleiterplatten herstellen kann. Die Herstellung dieser Verbindungen bedingt jedoch erheblichen Arbeitsaufwand und birgt die Gefahr in sich, dass einzelne Steckverbindungen vergessen werden, so dass die Funktion des Gerätes nicht gegeben ist.

Ein anderes elektronische Gerät ist aus der EP-A-0 194 962 bekannt.

Der Erfindung liegt das Problem zugrunde, ein elektronisches Gerät der eingangs genannten Art so auszubilden, dass die erforderlichen elektrischen Verbindungen zwischen den Hauptleiterplatten auf besonders einfache Weise und zuverlässig vorgenommen werden können.

Dieses Problem wird erfindungsgemäß dadurch gelöst, dass an der Frontseite des elektronischen Gerätes eine quer zu den Hauptleiterplatten ausgerichtete Verbindungsleiterplatte mit weiteren, in das jeweilige Steckverbindungsteil der Hauptleiterplatten eingreifenden Steckverbindungsteilen vorgesehen ist.

Durch diese Gestaltung des elektronischen Gerätes ist es nach der Montage der Hauptleiterplatten lediglich erforderlich, die Verbindungsleiterplatte mit ihren Steckverbindungsteilen von vorn her auf die Hauptleiterplatten zu stecken, um die erforderlichen Verbindungen zwischen den Hauptleiterplatten herzustellen. Dadurch entfällt die Notwendigkeit, die erforderlichen elektrischen Verbindungen einzeln und nacheinander durch Schließen von Steckverbindungen zwischen den einzelnen Hauptleiterplatten zu erzeugen, so dass das erfindungsgemäße elektronische Gerät schneller zu montieren ist als die bisher bekannten. Geräte und zwangsläufig sichergestellt ist, dass alle elektrischen Verbindungen geschlossen werden.

Die elektrischen Verbindungen sind gleichzeitig mit der Montage der Frontplatte geschlossen werden, da gemäß der Erfindung die Verbindungsleiterplatte an einem Bedienelemente des elektronischen Gerätes aufweisenden Frontplatte vorgesehen ist.

Alternativ ist es jedoch auch möglich, wenn die Verbindungsleiterplatte an ihrer der Frontleiterplatte zugewandten Seite zumindest eine Steckverbindung zum Verbinden mit einer Nebenleiterplatte in der Frontplatte hat.

Die Verbindungsleiterplatte kann zusätzlich zu ihrer Funktion der Stromverteilung die Funktion einer Platine erhalten, indem die Verbindungsleiterplatte durch auf sie angeordnete elektronische Bauteile eine Nebenleiterplatte bildet.

Da infolge von Fertigungstoleranzen damit gerechnet werden muss, dass die Steckverbindungsteile der Hauptleiterplatten nicht alle mit den Steckverbindungsteilen der Verbindungsleiterplatte fluchten, ist es vorteilhaft, wenn man die Möglichkeit eines Toleranzausgleichs vorsieht. Diese kann sehr einfach dadurch geschaffen werden, dass die Steckverbindungsteile der Verbindungsleiterplatte und/oder der Hauptleiterplatten quer zur Steckrichtung begrenzt verschieblich angeordnet sind. Solche Steckverbindungsteile sind im Handel unter der Bezeichnung Board-to-Board Konnektoren erhältlich.

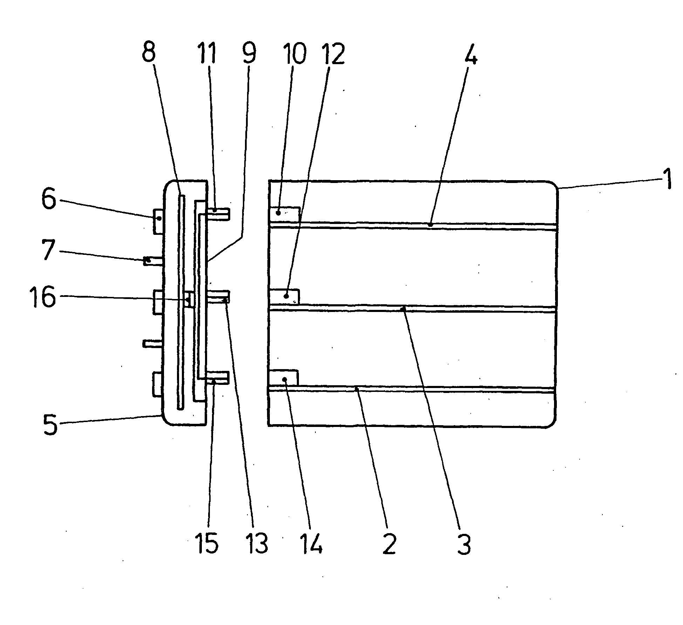

Die Erfindung lässt verschiedene Ausführungsformen zu. Zur weiteren Verdeutlichung ihres Grundprinzips ist eine davon stark schematisch in der Zeichnung dargestellt und wird nachfolgend beschrieben.

Die Zeichnung zeigt von einem elektronischen Gerät ein Gehäuse 1, in welchem übereinander drei Hauptleiterplatten 2, 3, 4 angeordnet sind. Die unterste Hauptleiterplatte 2 kann beispielsweise die elektronischen Bauteile für ein Radio, die mittlere Hauptleiterplatte 3 die elektronischen Bauteile für ein Multimediagerät und die obere Hauptleiterplatte 4 die elektronischen Bauteile für eine Fahrzeugnavigation tragen.

Das Gehäuse 1 lässt sich von einer vor seiner vorderen Stirnseite dargestellten Frontplatte 5 verschließen. Diese weist Bedienelemente 6, 7 für die einzelnen Einrichtungen des Gerätes auf und hat in ihrem Inneren eine Nebenleiterplatte 8. An der der Frontseite des Gehäuses 1 zugewandten Seite hat die Frontplatte eine Verbindungsleiterplatte 9.

Wichtig für die Erfindung ist, dass die einzelnen Hauptleiterplatten 2, 3, 4 an ihrer Vorderseite und die Verbindungsleiterplatte 9 an ihrer dem Gehäuse 1 zugewandten Seite Steckverbindungsteile 10 bis 15 aufweisen, wobei beim Aufschieben der Frontplatte 5 die Steckverbindungsteile 11, 13, 15 der Frontplatte 5 in die Steckverbindungsteile 10, 12, 14 der Hauptleiterplatten 2, 3, 4 gelangen und dadurch elektrische Verbindungen zwischen den Hauptleiterplatten 2, 3, 4 über die Verbindungsleiterplatte 9 herstellen.

Bei dem gezeigten Ausführungsbeispiel ist die Verbindungsleiterplatte 9 über eine Steckverbindung 16 mit der Nebenleiterplatte 8 verbunden. Es ist jedoch auch möglich, auf die Nebenleiterplatte 8 zu verzichten und die auf ihr unterzubringenden, elektronischen Bauteile auf der Verbindungsleiterplatte 9 anzuordnen.

## Patentansprüche

1. Elektronisches Gerät mit mehreren, übereinander oder nebeneinander in einem Gehäuse angeordneten Hauptleiterplatten, von denen eine beispielsweise elektronische Bauteile eines Radios, die andere elektronische Bauteile eines Multimediagerätes und eine dritte elektronische Bauteile einer Fahrzeugnavigation trägt und die zur elektrischen Verbindung miteinander an ihrer Vorderseite jeweils ein Steckverbindungsteil aufweisen, wobei an der Frontseite des elektronischen Gerätes eine quer zu den Hauptleiterplatten (2, 3, 4)ausgerichtete Verbindungsleiterplatte (9) mit weiteren, in das jeweilige Steckverbindungsteil (10, 12, 14) der Hauptleiterplatten (2, 3, 4) eingreifenden Steckverbindungsteilen (11, 13, 15) vorgesehen ist, wobei eine Bedienelemente (6, 7) des elektronischen Gerätes aufweisenden Frontplatte (5) vorgesehen ist, **dadurch gekennzeichnet, dass** die Frontplatte (5) an der der Frontseite des Gehäuses (1) zugewandten Seite die Verbindungsleiterplatte (9) hat, so dass die elektrischen Verbindungen zwischen der Verbindungsleiterplatte (9) und den Hauptleiterplaten (2,3,4) gleichzeitig mit der Montage der Frontplatte (5) geschlossen werden.

## Claims

1. Electronic unit having a plurality of main printed circuit boards arranged one above or beside the other in a case, of which, for example, one carries electronic components of a radio, the other carries electronic components of a multimedia device and a third carries electronic components of a vehicle navigation system, and each of which comprise on their front side a plug-in connection part for connecting them together electrically, with a connection printed circuit board (9) being provided on the front side of the electronic unit, said board being arranged at right angles to the main printed circuit boards (2, 3, 4) and having additional plug-in connection parts (11, 13, 15) that engage in the respective plug-in connection part (10, 12, 14) of the main printed circuit boards (2, 3, 4), where a front panel (5) holding controls (6, 7) of the electronic unit is provided,
**characterized in that** on the side facing the front face of the case (1), the front panel (5) has the connection printed circuit board (9), so that the electrical connections between the connection printed circuit board (9) and the main printed circuit boards (2, 3, 4) is made at the same time as the front panel (5) is fitted.

## Revendications

1. Appareil électronique comportant plusieurs cartes principales à circuits imprimés, disposées dans un boîtier l'une au-dessus de l'autre ou l'une à côté de l'autre, où l'une d'entre elles porte, à titre d'exemple, des composants électroniques d'un poste radio, l'autre, des composants électroniques d'un appareil multimédia et une troisième, des composants électroniques d'un appareil de navigation automobile et ont, sur leur face avant, chacune une pièce de raccordement enfichable permettant leur raccordement électrique l'une avec l'autre, où, sur la face avant de l'appareil électronique, il est prévu une carte à circuits imprimés de raccordement (9), orientée perpendiculairement aux cartes principales à circuits imprimés (2, 3, 4) et comportant d'autres pièces de raccordement enfichables (11, 13, 15) s'engageant dans la pièce de raccordement enfichable respective (10, 12, 14) des cartes principales à circuits imprimés (2, 3, 4), où il est prévu une platine avant (5) comportant des éléments de commande (6, 7) de l'appareil électronique, **caractérisé par le fait que** la platine avant (5) a, sur le côté tourné vers la face avant du boîtier (1), la carte à circuits imprimés de raccordement (9), si bien que les liaisons électriques entre la carte à circuits imprimés de raccordement (9) et les cartes principales à circuits imprimés (2, 3, 4) sont établies en même temps que le montage de la platine avant (5).
